(19) Europäisches Patentamt
European Patent Office
Office européen des brevets

(11) **EP 2 525 639 A2**

(12) **EUROPEAN PATENT APPLICATION**

(43) Date of publication:
**21.11.2012 Bulletin 2012/47**

(51) Int Cl.:
***H05K 7/20*** *(2006.01)*

(21) Application number: **12168238.9**

(22) Date of filing: **16.05.2012**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **18.05.2011 JP 2011111693**

(71) Applicant: **Hitachi Plant Technologies, Ltd.**
**Tokyo**
**170-8466 (JP)**

(72) Inventors:
• **Kashirajima, Yasuhiro**
**Tokyo, 170-8466 (JP)**

• **Ito, Junichi**
**Tokyo, 170-8466 (JP)**
• **Inadomi, Yasuhiko**
**Tokyo, 170-8466 (JP)**
• **Yoshida, Tomohiro**
**Tokyo, 170-8466 (JP)**
• **Mikami, Teruo**
**Tokyo, 170-8466 (JP)**

(74) Representative: **Beetz & Partner**
**Patentanwälte**
**Steinsdorfstrasse 10**
**80538 München (DE)**

(54) **Cooling system for electronic equipment**

(57) A cooling system 2 for electronic equipment includes an evaporator 21 cooling the electronic equipment, a blower 26 making air heated by the electronic equipment flow into the evaporator 21, and a condenser 22 condensing a refrigerant to be supplied to the evaporator 21 and also includes a refrigerant liquid pipe 23 guiding a liquefied refrigerant from the condenser to a lower part of the evaporator, a refrigerant gas pipe 24 guiding the refrigerant which evaporates by cooling the electronic equipment from an upper part of the evaporator to the condenser, a refrigerant flow rate control valve 25 controlling a flow rate of the refrigerant flowing into the evaporator 21, a temperature sensor 27 detecting a temperature of air obtained after passing through the evaporator 21, and a controller 28 for control valve controlling the control valve 25 on the basis of a detection value of the temperature sensor 27.

*FIG. 1*

**Description**

BACKGROUND OF THE INVENTION

Field of the Invention

The present invention relates to a cooling system for electronic equipment which is favorably used, in particular, for cooling electronic equipment which is to be operated with precision and is large in quantity of heat generated therefrom such as a computer, a server and the like.

Description of the Related Art

As a cooling system for cooling heat generated when electronic equipment such as a server or the like is operated, variouis systems such as an air cooling system, a water cooling system and the like are proposed.

In particular, since a cooling system of the type that refrigerant natural circulation for naturally circulating a refrigerant without power is utilized uses neither a pump nor a compressor, it attracts notice as an energy saving cooling system running cost of which is expected to be reduced.

For example, Japanese Patent Application Laid-Open No. 2009-217500 discloses a cooling system for electronic equipment in which an evaporator for cooling a hot blast (air) which has been discharged from electronic equipment such as a server or the like is disposed and a temperature sensor which detects a temperature of air obtained after the air has been cooled is disposed downstream of the evaporator such that the opening of a valve for controlling a flow rate of a refrigerant which flows within the evaporator is adjusted on the basis of a detection value or the like of the temperature sensor to control an outlet temperature of the evaporator so as to approximate to a set value.

In the system which is disclosed in Japanese Patent Application Laid-Open No. 2009-217500, a temperature sensor is disposed on the middle of the downstream side of the evaporator so as to adjust the flow rate of the refrigerant which flows within the evaporator on the basis a result of detection by the temperature sensor. However, in a cooling system of the type using a refrigerant natural circulation system, although the refrigerant is in a liquefied state on the side of an inlet (a lower part) into the evaporator, since the quantity of heat generated from the electronic equipment is increased when the electronic equipment is fully operated, most of the refrigerant evaporates to a gaseous refrigerant on the side of an outlet (an upper part) of the evaporator. Therfefore, on the upper part side of the evaporator, a difference between a temperature obtained when the electronic equipment is not so fully opetated and a temperature obtained when the electronic equipment is fully operated is increased to such an extent that the temperature sensor disposed on the middle of the downstream side of the evaporator may not sufficiently cope with the operating status of the electronic equipment and hence stable control of the electronic equipment may not be attained. However, nothing may be considered for the above mentioned situation.

SUMMARY OF THE INVENTION

Therefore, an object of the present invention is to provide a cooling system for electronic equipment which is configured to appropriately adjust a flow rate of a refrigerant which flows within an evaporator, coping with the operating status of the electronic equipment, thereby attaining stable control of the electronic equipment.

In order to attain the above mentioned object, according to one embodiment of the present invention, there is provided a cooling system for electronic equipment of the type including an evaporator which evaporates a refrigerant with heat generated from electronic equipment, a blower which makes air which is heated with the heat generated from the electronic equipment flow into the evaporator, and a condenser which is disposed higher than the evaporator and cools and condenses the refrigerant to be supplied to the evaporator to a liquefied refrigerant, and including a refrigerant liquid pipe which guides the liquefied refrigerant from the condenser to a lower part of the evaporator, a refrigerant gas pipe which guides the refrigerant from an upper part of the evaporator to the condenser, a refrigerant flow rate control unit which controls a flow rate of the refrigerant in accordance with a temperature of air obtained after the air has passed through the evaporator and a temperature sensor which detects the temperature of the air obtained after the air has passed through the evaporator, wherein the temperature sensor is disposed on the side of an air outlet of the evaporator and higher than a half of the height of the evaporator.

Here, desirably, the evaporator includes a coiled vertical pipe through which the refrigerant flows upward from below and the temperature sensor is disposed higher than a half of the height of the coiled vertical pipe. Desirably, the temperature sensor is disposed lower than an upper end of the evaporator. More desirably, the temperature sensor is disposed lower than an upper end of the coiled vertical pipe.

According to another embodiment of the present invention, there is provided a cooling system for electronic equipment of the type including an evaporator which evaporates a refrigerant with heat generated from electronic equipment, a blower which makes air which is heated with the heat generated from the electronic equipment flow into the evaporator, and a condenser which is disposed higher than the evaporator and cools and condenses the refrigerant to be supplied to the evaporator to a liquefied refrigerant, and including a refrigerant liquid pipe which guides the liquefied refrigerant from the condenser to a lower part of the evaporator, a refrigerant gas pipe which guides the refrigerant from an upper part of the evaporator to the condenser, a refrigerant flow rate control valve which is disposed in at least one of the refrigerant liquid pine and the refrigerant gas pipe and controls a flow rate of the refrigerant which flows within the evaporator, a temperature sensor which detects a temperature of air obtained after the air has passed through the evaporator and a controller for control valve which controls the refrigerant flow rate control valve on the basis of a detection value of the temperature sensor, wherein the temperature sensor is disposed on the side of an air outlet of the evaporator and on an upper part of the evaporator.

Here, desirably, when a temperature value which is detected by the temperature sensor is higher than a predetermined value, the controller for control valve increases the opening of the refrigerant flow rate control valve to increase the flow rate of the liquefied refrigerant to be supplied to the evaporator, and when a temperature value which is detected by the temperature sensor is lower than a predetermined value, the controller for control valve decreases the opening of the refrigerant flow rate control valve to decrease the flow rate of the liquid refrigerant to be supplied to the evaporator.

In particular, the present invention is favorably applicable to the system in which the refrigerant is conveyed between the evaporator and the condenser by a refrigerant natural circulation system.

Desirably, the blower is disposed downstream of the evaporator and the temperature sensor is disposed between the evaporator and the blower. Preferably, a plurality of the blowers is vertically disposed on the evaporator and the temperature sensor is disposed in the vicinity of a blower which is disposed at an upper stage in the plurality of blowers.

The electronic apparatus may be cooled even when an outdoor temperature is high by configuring such that the condenser condenses a gaseous refrigerant which flows into it through the refrigerant gas pipe by being cooled by a refrigerating machine.

As an alternative, the condenser may condense a gaseous refrigerant which flows into it through the refrigerant gas pipe by being cooled with outside air or external cooling water.

In addition, such a configuration may be possible that the condenser is a condenser which is included in a refrigerating machine, the evaporator is an evaporator which is included in the refrigerating machine, a gaseous refrigerant which is sent through the refrigerant gas pipe is compressed by a compressor included in the refrigerating machine, is sent to the condenser and is condensed to a liquefied refrigerant through heat exchange with outside air or external cooling water, and the liquefied refrigerant so condensed by the condenser is sent to the refrigerant liquid pipe and a refrigerant flow rate control valve which is configured using an electronic expansion valve is disposed in the refrigerant liquid pipe as the refrigerant flow rate control unit so as to expand the refrigerant while controlling the flow rate of the refrigerant by the refrigerant flow rate control valve, thereby making the refrigerant flow into the evaporator.

More preferably, a plurality of the evaporator are disposed, the refrigerant flow rate control valve is disposed in the refrigerant liquid pipe, the refrigerant liquid pipe is branched into respective pipes on the downstream side of the refrigerant flow rate control valve and the branched pipes are connected to lower parts of the plurality of evaporators, a plurality of refrigerant gas pipes are respectively connected to upper parts of the plurality of evaporators, the plurality of refrigerant gas pipes are configured to be united together so as to guide a gaseous refrigerant to the condenser, a plurality of the temperature sensors are respectively disposed on upper parts of the respective evaporators, and the refrigerant flow rate control valve is configured to be controlled by the controller for control valve on the basis of detection values of the respective temperature sensors.

Desirably, the refrigerant flow rate control valve is controlled by the controller for control valve such that a mean value of the detection values detected by the temperature sensors disposed on the respective evaporators is within a predetermined temperature range. Also desirably, the refrigerant flow rate control valve is controlled by the controller for control valve such that a maximum detection value of the detection values detected by the temperature sensors disposed on the respective evaporators is within a predetermined temperature range.

According to the present invention, since it is allowed to appropriately adjust a flow rate of a refrigerant which flows within an evaporator, coping with the operating status of electronic equipment, a cooling system for electronic equipment by which stable control of the electronic equipment is attained may be obtained.

BRIEF DESCRIPTION OF THE DRAWINGS

FIG. 1 is a schematic diagram of a general configuration, illustrating an embodiment 1 of a cooling system for electronic equipment according to the present invention;

FIG. 2 is a schematic side view of the cooling system illustrated in FIG. 1, viewed from the side of a blower;

FIG. 3 is a diagram illustrating a manner that a liquefied refrigerant evaporates to a gaseous refrigerant in an evaporator illustrated in FIG. 1;

FIG. 4 is a flowchart illustrating a flow of control by a controller in the embodiment 1 of the present invention;

FIG. 5 is a schematic diagram of a configuration of essential parts, illustrating an embodiment 2 of the cooling system for electronic equipment according to the present invention; and

FIG. 6 is a flowchart illustrating a flow of control by a controller in the embodiment 2 of the present invention.

DESCRIPTION OF THE PREFERRED EMBODIMENTS

Hereinafter, specific embodiments of the present invention will be described with reference to the accompanying drawings.

[Embodiment 1]

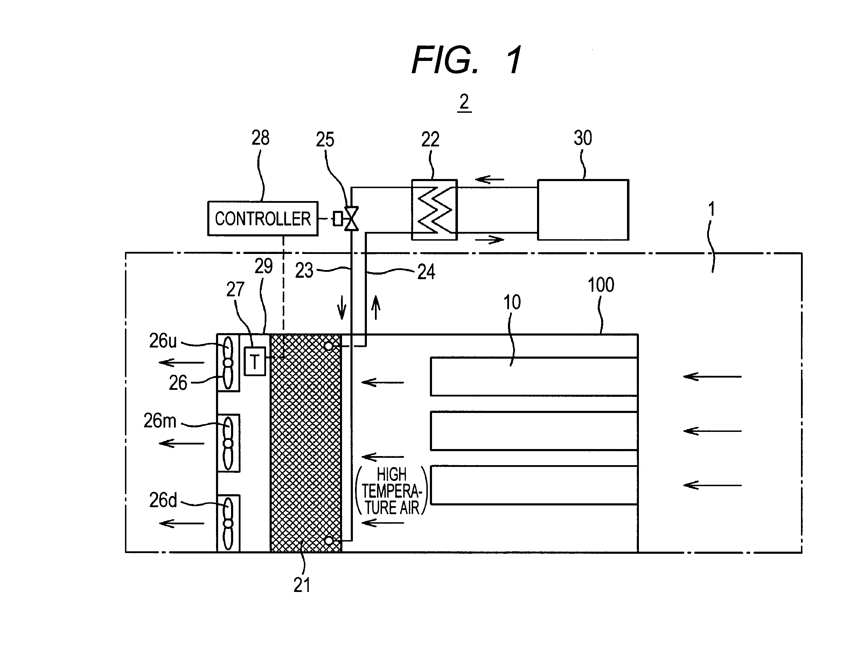

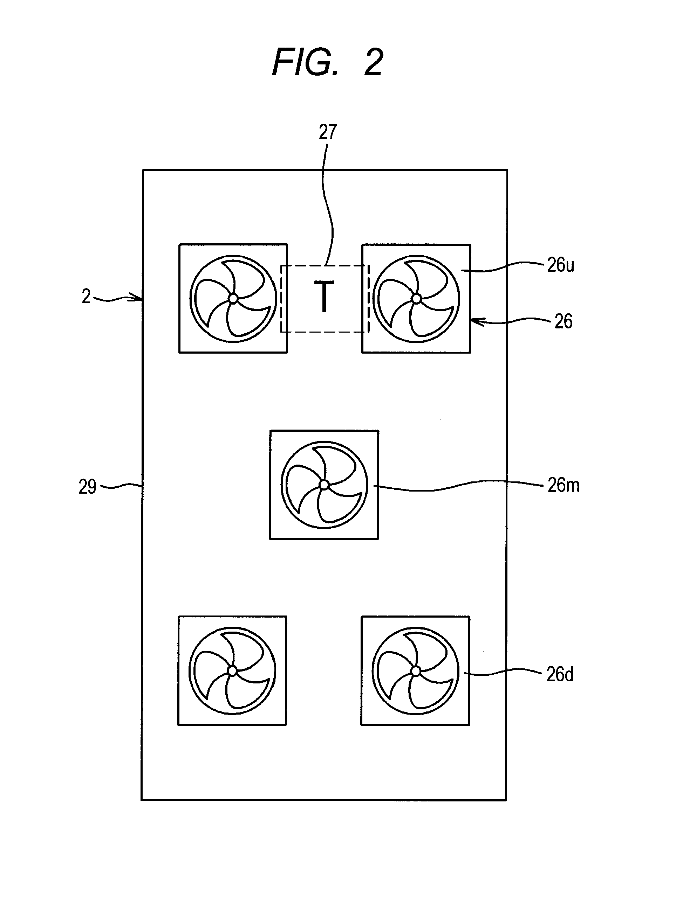

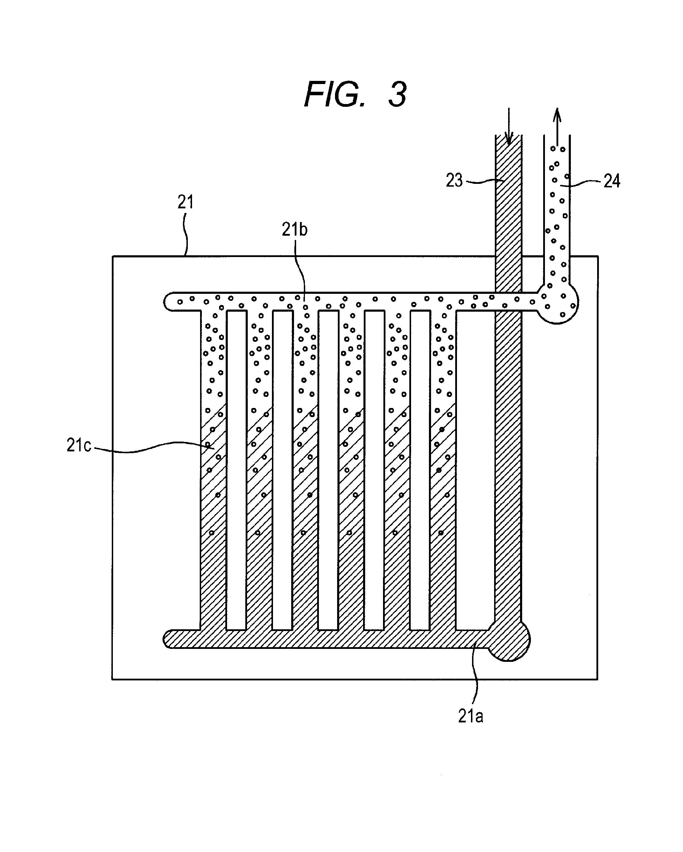

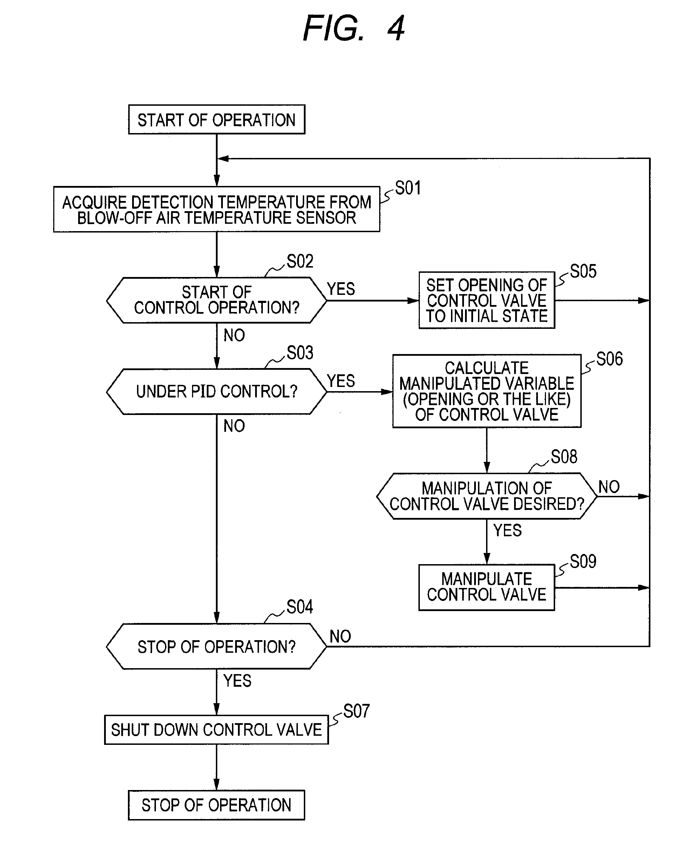

An embodiment 1 of a cooling system for electronic equipment according to the present invention will be described with reference to FIG. 1 to FIG. 4. FIG. 1 is a schematic diagram of a general configuration, illustrating an embodiment 1 of a cooling system for electronic equipment according to the present invention. FIG. 2 is a schematic side view of the cooling system illustrated in FIG. 1, viewed from the side of a blower. FIG. 3 is a diagram illustrating a manner that a liquefied refrigerant evaporates to a gaseous refrigerant in an evaporator illustrated in FIG. 1. FIG. 4 is a flowchart illustrating a flow of control by a controller in the embodiment 1 of the present invention.

FIG. 1 illustrates a cooling system for electronic equipment 2 which cools a server as electronic equipment. In FIG. 1, 1 is a server room which is installed within a building. A plurality of server racks 100 (only one server rack is illustrated in FIG. 1), each housing the servers (electronic equipment) 10, are installed in the server room 1. In the embodiment 1, a blade type server is given as an example of the server 10 to be cooled. The blade type server 10 is a thin-type server. Although, in general, a plurality of the thin-type servers is loaded on the server rack 100, the server 10 may be one large-sized server. Air is taken into the server 10 from a front surface (on the right side in FIG. 1) of the server rack 100 and turns to a hot blast by cooling the hot server 10. The air which has flown out from the server rack 100 is sent toward an evaporator 21 in the cooling system 2.

The cooling system 2 includes the evaporator 21 and a condenser 22 which are used to cool the hot blast from the server 10, a refrigerant liquid pipe 23 which guides a liquefied refrigerant which has been condensed by the condenser 22 to a lower part of the evaporator 21, a refrigerant gas pipe 24 which returns a gaseous refrigerant which has evaporated through heat exchange with the hot blast from the server 10 in the evaporator 21 from an upper part of the evaporator 21 to the condenser 22, a refrigerant flow rate control valve (a refrigerant flow rate control unit) 25 which is disposed in the refrigerant liquid pipe 23 to control a flow rate of the liquefied refrigerant flowing into the evaporator 21, a blower 26, that is, a plurality of blowers which are installed downstream of the evaporator 21 so as to introduce air in the server room 1 into the server rack 100, to cool the air which has been heated by cooling the server 10 by passing it through the evaporator 21, and to blow off the cooled air again into the server room 1, a temperature sensor (for example, a blown-off air temperature sensor) 27 which is disposed between the evaporator 21 and the blower 26 and on an upper part of the evaporator 21 to detect a temperature of blown-off air which is blown off from the evaporator 21, a controller for control valve 28 which controls the opening of the refrigerant flow rate control valve 25 on the basis of a detection value obtained by the temperature sensor 27, a casing 29 which houses the evaporator 21, the blower 26 and the temperature sensor 27 installed in the server room 1 and the like.

The blower 26 includes an upper blower 26u disposed on a downstream-side upper part of the evaporator, a middle blower 26m disposed on a downstream-side middle part thereof, and a lower blower 26d disposed on a downstream-side lower part thereof. As illustrated in FIG. 2, two blowers are installed as the upper blower 26u, one blower is installed as the middle blower 26m, and two blowers are installed as the lower blower 26d. Each blower includes a propeller and a motor (not illustrated in FIG. 2) for driving the propeller. Air in the server room 1 is introduced into the server rack 100 by rotating the propeller, passes through the server 10, passes through the evaporator 21 and is again blown off into the server room 1.

The number of the blowers 26 to be installed and an arrangement configuration thereof are not limited to those illustrated in FIG. 2. In the embodiment 1, the condenser 22 is configured to condense a gaseous refrigerant which flows into the condenser through the refrigerant gas pipe 24 by cooling it by a refrigerating machine 30. The refrigerating machine 30 configures a refrigeration cycle by compressing a refrigerant by a compressor. However, the condenser 22 may be configured to condense a gaseous refrigerant which flows into the condenser through the refrigerant gas pipe 24 by cooling it with outside air or external cooling water, instead of installation of the refrigerating machine 30.

The temperature sensor 27 is disposed between the evaporator 21 and the blower 26 and in the vicinity of the upper blower 26u which is disposed on an upper part of the evaporator 21 as illustrated in FIG. 1 and FIG. 2, and, more specifically, is disposed between the two upper blowers 26u (on an axial central part of the evaporator) in the example illustrated in FIG. 2. The temperature of air which flows out from an upper part of the evaporator 21 may be more accurately and stably detected by positioning the temperature sensor 27 as mentioned above.

A detection value of the temperature sensor 27 is sent to the controller 28. The controller 28 controls the opening of the refrigerant flow rate control valve 25 on the basis of the detection value so as to set the temperature of air on the outlet side of the evaporator 21 to a predetermined value (or within a predetermined temperature range). That is, when the detection value of the temperature sensor 27 is higher than a predetermined value, the controller 28 controls to increase the opening of the refrigerant flow rate control valve 25 to increase the flow rate of the liquefied refrigerant which flows through the refrigerant liquid pipe, thereby increasing the cooling capacity of the evaporator 21. While, when the detection value is lower than the predetermined value, the controller 28 controls to decrease the opening of the refrigerant flow rate control valve 25 to decrease the flow rate of the liquefied refrigerant which flows through the refrigerant liquid pipe, thereby decreasing the cooling capacity of the evaporator 21.

The temperature sensor 27 is disposed on the air outlet side of the evaporator 21 and higher than a half of the height of the evaporator 21. Explaining in more detail, the evaporator 21 includes a coiled vertical pipe through which the refrigerant flows upward from below and the temperature sensor 27 is disposed at a position which is higher than that of a half of the height of the coiled vertical pipe.

It is desirable that the temperature sensor 27 is disposed lower than an upper end part of the evaporator 21 and it is preferable that the temperature sensor 27 be disposed lower than an upper end part of the coiled vertical pipe. In the embodiment 1, the temperature sensor 27 is configured to be disposed at a height-wise position which is within 10 % when measured downward from the upper end part of the evaporator 21.

Control to almost complete evaporation of a liquefied refrigerant on an upper part of the evaporator may be facilitated, efficiency of heat exchange of the entire evaporator may be increased, and stable refrigerant natural circulation may be attained by configuring the temperature sensor 27 as mentioned above. That is, since the temperature sensor 27 is disposed on an upper part of the evaporator 21 and a part of the evaporator corresponding to the sensor disposed position is a place where the liquefied refrigerant is liable to evaporate to a gas, the detected temperature of air faithfully conforms to the status of the evaporator 21 and hence a change in temperature may be grasped sensitively.

A manner that a liquefied refrigerant evaporates to a gaseous refrigerant in the evaporator 21 illustrated in FIG. 1 will be described with reference to FIG. 3. As illustrated in FIG. 3, the evaporator 21 includes a lower horizontal pipe 21a, an upper horizontal pipe 21b and a plurality of vertical pipes 21c which connect together the lower horizontal pipe 21a and the upper horizontal pipe 21b and each vertical pipe 21c is configured using a coiled heat-transfer pipe. The refrigerant liquid pipe 23 is connected to the lower horizontal pipe 21a and the refrigerant gas pipe 24 is connected to the upper horizontal pipe 21b.

A liquefied refrigerant which is obtained by being condensed in the condenser 22 flows downward through the refrigerant liquid pipe 23, is supplied to the lower horizontal pipe 21a, flows into the refrigerant gas pipe 24 from the pipe 21a and goes upward. Air heated by the server 10 is cooled through heat exchange with the refrigerant which goes upward through the vertical pipe 21c when passing through the evaporator 21 and the liquefied refrigerant which passes through the vertical pipe 21c evaporates to a gaseous refrigerant. The gaseous refrigerant flows into the refrigerant gas pipe 24 through the upper horizontal pipe 21b, goes upward and is returned to the condenser 22. As described above, in the embodiment 1, the server (electronic equipment) 10 is cooled by a refrigerant natural circulation system.

For example, R-134a (HFC-134a) may be used as the refrigerant to be naturally circulated. Although the state of the refrigerant in the vertical pipe 21c depends on the operating status on the side of electronic equipment used, for example, 80 % of the refrigerant is in a liquefied state and 20 % of the refrigerant is in a gaseous state on a lower part of the vertical pipe 21c, and 5 % of the refrigerant is in a liquefied state and 95 % of the refrigerant is in a gaseous state on an upper part of the vertical pipe 21c. The gaseous refrigerant which has been returned to the condenser 22 is cooled by the refrigerating machine 30 and is again condensed. Incidentally, the gaseous refrigerant which has been returned to the condenser may be cooled with outside air or external cooling water as described above. The refrigerant which has been condensed to a liquefied refrigerant in the condenser 22 again flows out toward the refrigerant liquid pipe 23.

Next, a flow of control performed by the controller 28 in the embodiment 1 of the present invention will be described with reference to a flowchart in FIG. 4.

When operation is started, first, a detection temperature T is acquired by the temperature sensor 27 (Step S01). Next, the process proceeds to Step S02. When a controlling operation of the refrigerant flow rate control valve 25 is started (operation is started), the opening of the control valve 25 is set to its initial state (Step S05) and the process returns to Step S01.

When the controlling operation is not started in Step S02, the process proceeds to Step S03. For example, when the control valve 25 is under PID control, the process proceeds to Step S06 and a manipulated variable (the opening or the like) of the control valve 25 is calculated on the basis of the detection value T of the blown-off air temperature which has been acquired in Step S01. Next, whether manipulation of the control valve 25 is desirable is determined in Step S08. When manipulation is not desirable, the process returns Step S01. While, when manipulation is desirable, desirable manipulation such as change of the opening of the control valve or the like is performed and then the process returns to Step S01.

Incidentally, the above mentioned PID control is a kind of feedback control, that is, a controlling method by which an input value is controlled on the basis of three elements of proportional (or deviation) between an output value and a target value, integral thereof and differential thereof.

When PID control is not being performed or is not performed in Step S03, the process proceeds to Step S04. When the operation of the cooling system is not stopped, the process returns to Step S01. While, when the operation is stopped, the control valve 25 is shut down (Step S07) and the operation of the cooling system is stopped.

[Embodiment 2]

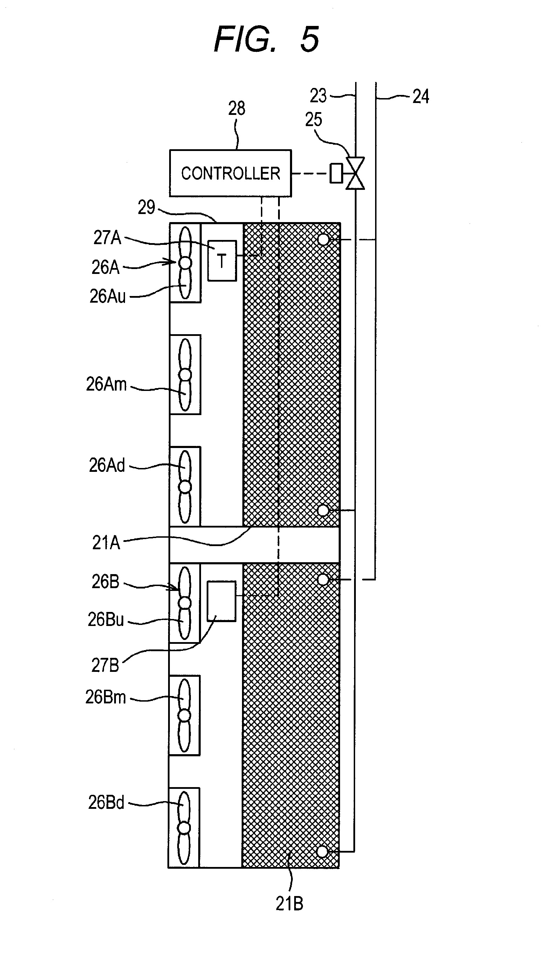

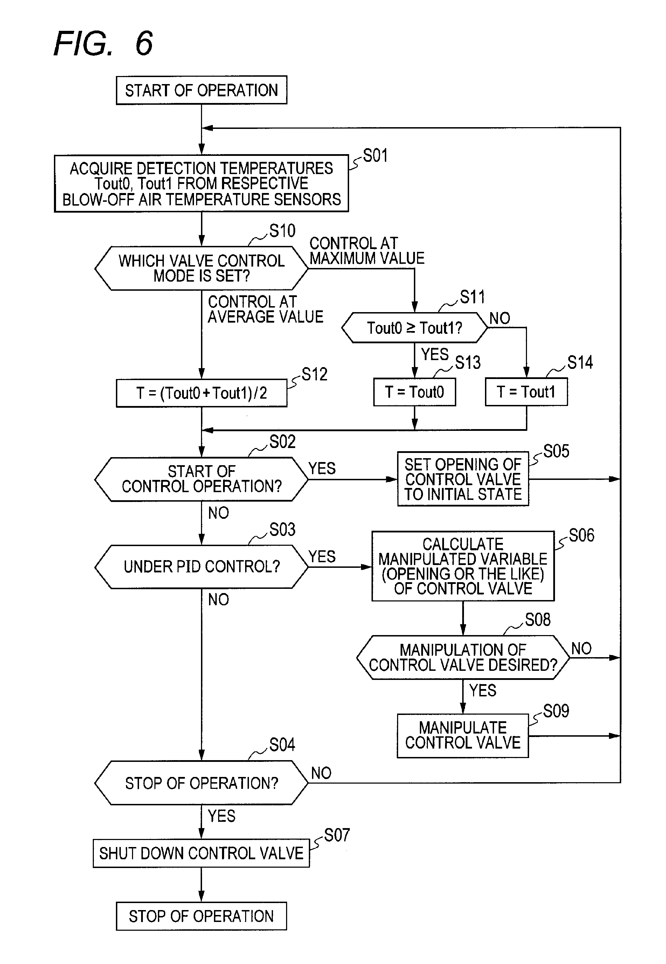

An embodiment 2 of the present invention will be described with reference to FIG. 5 and FIG. 6. FIG. 5 is a schematic diagram of a configuration of essential parts, illustrating the embodiment 2 of the cooling system for electronic equipment of the present invention. FIG. 6 is a flowchart illustrating a flow of control which is performed by a controller in the embodiment 2 of the present invention.

Although in the embodiment 1, a case in which only one evaporator is connected to one cooling system for electronic component (a server) to be cooled has been described by way of example, in the embodiment 2, an example in which a plurality (two in this embodiment) of evaporators are connected to one cooling system will be described. That is, the embodiment 2 involves an example in which two evaporators are connected to one refrigerant circulation cycle. In FIG. 5 and FIG. 6, the same numerals as those in FIG. 1 to FIG. 4 designate the same or corresponding parts.

As illustrated in FIG. 5, in the embodiment 2, two evaporators 21A and 21B are vertically disposed and temperature sensors (for example, blown-off air temperature sensors) 27A and 27B are disposed on air-outlet-side upper parts of the respective evaporators 21A and 21B. Three blowers 26A (26Au, 26Am and 26Ad) and three blowers 26B (26Bu, 26Bm and 26Bd) are vertically disposed on the outlet sides of the evaporators 21A and 21B. The temperature sensors 27A and 27B are connected to the controller 28 for control valve and the controller 28 is configured to control the opening or the like of the refrigerant flow rate control valve 25 on the basis of detection values obtained by the temperature sensors 27A and 27B.

Next, control of the control valve 25 which is performed by the controller 28 for control valve on the basis of the detection values of the temperature sensors 27A and 27B will be described.

In a first example, a mean value is obtained by the arithmetical mean of values detected by the both temperature sensors 27A and 27B and the control valve 25 is controlled on the basis of the mean value. That is, when the mean value of temperatures detected by the temperature sensors 27A and 27B is higher than a predetermined value, the opening of the refrigerant flow rate control valve 25 is increased to increase the flow rate of a refrigerant which flows into the respective evaporators 21A and 21B through the refrigerant liquid pipe 23, thereby increasing the cooling capacities of the evaporators 21A and 21B. While, when the mean value of temperatures detected by the temperature sensors 27A and 27B is lower than the predetermined value, the opening of the refrigerant flow rate control valve 25 is decreased to decrease the flow rate of the refrigerant which flows into the respective evaporators 21A and 21B through the refrigerant liquid pipe 23, thereby decreasing the cooling capacities of the evaporators 21A and 21B.

In a second example of control of the control valve 25 by the controller 28 for control valve, the control valve 25 is controlled on the basis of a maximum detection value of values detected by the plurality of temperature sensors 27A and 27B. That is, when the maximum detection value of detection values detected by the temperature sensors 27A and 27B is higher than a predetermined value, the opening of the refrigerant flow rate control valve 25 is increased, thereby increasing the cooling capacities of the evaporators 21A and 21B. While, when the maximum detection value of the detection values detected by the temperature sensors 27A and 27B is lower than the predetermined value, the opening of the refrigerant flow rate control valve 25 is decreased, thereby decreasing the cooling capacities of the evaporators 21A and 21B.

In the embodiment 2, it is desirable that each of the temperature sensors 27A and 27B be disposed at a height-wise position which is within 20 % when measured downward from an upper end part of each of the evaporators 21A and 21B. By disposing the sensors as mentioned above, control may be readily performed such that these two evaporations 21A and 21B are operated within a capacity (that is a 90 % capacity of a maximum cooling capacity) which is lower by 10 % than the maximum cooling capacity obtained by combining together the capacities of the two evaporators 21A and 21B. In addition, since control may be readily performed so as to almost complete evaporation of the liquefied refrigerant on an upper part of each evaporator, the heat exchange efficiency of the entire evaporator may be increased.

Next, a flow of control performed by the controller 28 in the embodiment 2 of the present invention will be described with reference to a flowchart in FIG. 6. The same numerals are assigned to parts which operate in the same manner as those in FIG. 4 and detailed description thereof will be omitted.

In the control flow in the embodiment 2, detection temperatures $T_{out}0$ and $T_{out}1$ are acquired from the temperature sensors 27A and 27B (step S01) and then the process proceeds to Step S10. In Step S10, in which control mode the controller 28 controls the flow rate control valve 25, that is, whether the controller 28 controls the control valve 25 on the basis of a mean value of detection values of the plurality of temperature sensors or a maximum value of the detection values is determined.

When the controller 28 controls the control valve 25 on the basis of a mean value of detection values of the temperature sensors 27A and 27B,

$$T = (T_{out}0 + T_{out}1)/2$$

is set (Step S12).

When the controller 28 controls the control valve 25 on the basis of a maximum value of the detection values of the temperature sensors 27A and 27B, whether

$$T_{out}0 \geq T_{out}1$$

is determined (Step S11). When Yes, "T = $T_{out}0$" is set (Step S13). When No, "T = $T_{out}1$" is set (Step S14).

In the succeeding operation, controlling operations which are the same as those in Step S02 to Step S09 which have been described in FIG. 4 are performed.

Although an example in which electronic equipment is cooled by a refrigerant natural circulation system has been described in each of the above mentioned embodiments, the present invention is not limited to the above. For example, the condenser 22 may be configured as a condenser included in a refrigerating machine and the evaporator 21 may be configured as an evaporator included in the refrigerating machine such that a gaseous refrigerant which is sent through the refrigerant gas pipe 24 is compressed by a compressor included in the refrigerating machine and is sent to the condenser 22 to condense the refrigerant so compressed through heat exchange with outside air or external cooling water. In the above mentioned case, such a configuration is also allowable that a liquefied refrigerant obtained by being condensed by the condenser 22 is sent to the refrigerant liquid pipe 23 and the refrigerant flow rate control valve 25 which is configured using an electronic control valve or the like is installed in the refrigerant liquid pipe so as to expand the refrigerant while controlling the flow rate thereof by the refrigerant flow rate control valve 25 to make the refrigerant flow into the evaporator 21.

According to each of the above mentioned embodiments, since a refrigerant liquid pipe for guiding a liquefied refrigerant from a condenser to a lower part of an evaporator, a refrigerant gas pipe for guiding the refrigerant which has evaporated by cooling electronic equipment from an upper part of the evaporator to the condenser, a refrigerant flow rate control valve (a refrigerant flow rate control unit) which is disposed in the refrigerant liquid pipe to control a flow rate of the refrigerant flowing into the evaporator, a temperature sensor for detecting a temperature of air obtained after passing through the evaporator, and a controller for control valve for controlling the refrigerant flow rate control valve on the basis of a detection value of the temperature sensor are included, and since the temperature sensor is disposed on the side of an air outlet of the evaporator and on an upper part of the evaporator, it is allowed to appropriately adjust the flow rate of the refrigerant which flows within the evaporator, coping with the operating status of the electronic equipment and hence it is allowed to obtain a cooling system for electronic equipment by which stable control is attained.

In particular, according to the embodiments of the present invention, even when the cooling system is configured as a cooling system for cooling electronic equipment by a refrigerant natural circulation system, stability of control may be improved.

**Claims**

1. A cooling system (2) for electronic equipment of the type comprising an evaporator (21) which evaporates a refrigerant with heat generated from electronic equipment, a blower (26) which makes air which is heated with the heat generated from the electronic equipment flow into the evaporator (21), and a condenser (22) which is disposed higher than the evaporator (21) and cools and condenses the refrigerant to be supplied to the evaporator to a liquefied refrigerant, comprising:

   a refrigerant liquid pipe (23) which guides the liquefied refrigerant from the condenser (22) to a lower part of the evaporator (21);
   a refrigerant gas pipe (24) which guides the refrigerant from an upper part of the evaporator (21) to the condenser (22);
   a refrigerant flow rate control unit (28) which controls a flow rate of the refrigerant in accordance with a temperature of air obtained after the air has passed through the evaporator; and
   a temperature sensor (27) which detects the temperature of the air obtained after the air has passed through the evaporator (21),

   wherein the temperature sensor (27) is disposed on the side of an air outlet of the evaporator (21) and higher than a half of the height of the evaporator (21).

2. The cooling system (2) for electronic equipment according to Claim 1,
   wherein the evaporator (21) includes a coiled vertical pipe (21c) through which the refrigerant flows upward from below, and the temperature sensor (27) is disposed higher than a half of the height of the coiled vertical pipe.

3. The cooling system (2) for electronic equipment according to Claim 1,
   wherein the temperature sensor (27) is disposed lower than an upper end of the evaporator (21).

4. The cooling system (2) for electronic equipment according to Claim 2,
   wherein the temperature sensor (27) is disposed lower than an upper end of the coiled vertical pipe.

5. A cooling system (2) for electronic equipment of the type comprising an evaporator (21) which evaporates a refrigerant with heat generated from electronic equipment, a blower (26) which makes air which is heated with the heat generated from the electronic equipment flow into the evaporator (21), and a condenser (22) which is disposed higher than the evaporator (21) and cools and condenses the refrigerant to be supplied to the evaporator to a liquefied refrigerant, comprising:

a refrigerant liquid pipe (23) which guides the liquefied refrigerant from the condenser (22) to a lower part of the evaporator (21);
a refrigerant gas pipe (24) which guides the refrigerant from an upper part of the evaporator (21) to the condenser (22);
a refrigerant flow rate control valve (25) which is disposed in at least one of the refrigerant liquid pipe (23) and the refrigerant gas pipe (24) and controls a flow rate of the refrigerant which flows within the evaporator (21);
a temperature sensor (27) which detects a temperature of air obtained after the air has passed through the evaporator (21); and
a controller (28) for control valve (25) which controls the refrigerant flow rate control valve on the basis of a detection value of the temperature sensor (27),

wherein the temperature sensor (27) is disposed on the side of an air outlet of the evaporator (21) and on an upper part of the evaporator (21).

6. The cooling system (2) for electronic equipment according to Claim 5,
wherein when a temperature value which is detected by the temperature sensor (27) is higher than a predetermined value, the controller (28) for control valve increases the opening of the refrigerant flow rate control valve (25) to increase the flow rate of the liquefied refrigerant to be supplied to the evaporator (21), and when a temperature value which is detected by the temperature sensor (27) is lower than a predetermined value, the controller (28) for control valve decreases the opening of the refrigerant flow rate control valve (25) to decrease the flow rate of the liquid refrigerant to be supplied to the evaporator (21).

7. The cooling system (2) for electronic equipment according to any one of Claims 1 to 6,
wherein the refrigerant is conveyed between the evaporator (21) and the condenser (22) by a refrigerant natural circulation system.

8. The cooling system for electronic equipment according to any one of Claims 1 to 7,
wherein the blower (26) is disposed downstream of the evaporator (21) and the temperature sensor (27) is disposed between the evaporator (21) and the blower (26).

9. The cooling system for electronic equipment according to Claim 8,
wherein a plurality of the blowers (26) is vertically disposed on the evaporator (21) and the temperature sensor (27) is disposed in the vicinity of a blower (26u) which is disposed at an upper stage in the plurality of blowers.

10. The cooling system for electronic equipment according to any of Claims 1 to 9,
wherein the condenser (22) condenses a gaseous refrigerant which flows into it through the refrigerant gas pipe (24) by being cooled by a refrigerating machine (30).

11. The cooling system for electronic equipment according to any of Claims 1 to 9,
wherein the condenser (22) condenses a gaseous refrigerant which flows into it through the refrigerant gas pipe (24) by being cooled with outside air or external cooling water.

12. The cooling system for electronic equipment according to any of Claims 1 to 11,
wherein the condenser (22) is a condenser which is included in a refrigerating machine, the evaporator (21) is an evaporator which is included in the refrigerating machine, a gaseous refrigerant which is sent through the refrigerant gas pipe (24) is compressed by a compressor included in the refrigerating machine, is sent to the condenser (22) and is condensed to a liquefied refrigerant through heat exchange with outside air or external cooling water, and the liquefied refrigerant so condensed by the condenser (22) is sent to the refrigerant liquid pipe and a refrigerant flow rate control valve (25) which is configured using an electronic expansion valve is disposed in the refrigerant liquid pipe as the refrigerant flow rate control unit so as to expand the refrigerant while controlling the flow rate of the refrigerant by the refrigerant flow rate control valve, thereby making the refrigerant flow into the evaporator.

13. The cooling system for electronic equipment according to any of Claims 5 to 12,
wherein a plurality of the evaporator (21A, 21B) are disposed, the refrigerant flow rate control valve (25) is disposed in the refrigerant liquid pipe (23), the refrigerant liquid pipe is branched into respective pipes on the downstream side of the refrigerant flow rate control valve (25) and the branched pipes are connected to lower parts of the plurality of evaporators (21A, 21B), a plurality of refrigerant gas pipes are respectively connected to upper parts of the plurality of evaporators, the plurality of refrigerant gas pipes are configured to be united together so as to guide a gaseous refrigerant to the condenser, a plurality of the temperature sensors (27A, 27B) are respectively disposed on upper parts of the respective evaporators, and the refrigerant flow rate control valve (25) is configured to be controlled by the controller (28) for control valve on the basis of detection values of the respective temperature sensors.

14. The cooling system for electronic equipment according to Claim 13,
   wherein the refrigerant flow rate control valve (25) is controlled by the controller (28) for control valve such that a mean value of the detection values detected by the temperature sensors disposed on the respective evaporators is within a predetermined temperature range.

15. The cooling system for electronic equipment according to Claim 13,
   wherein the refrigerant flow rate control valve (25) is controlled by the controller (28) for control valve such that a maximum detection value of the detection values detected by the temperature sensors disposed on the respective evaporators is within a predetermined temperature range.

FIG. 1

# FIG. 2

# FIG. 3

# FIG. 4

START OF OPERATION

ACQUIRE DETECTION TEMPERATURE FROM BLOW-OFF AIR TEMPERATURE SENSOR  — S01

START OF CONTROL OPERATION?  — S02 — YES → SET OPENING OF CONTROL VALVE TO INITIAL STATE — S05

NO

UNDER PID CONTROL?  — S03 — YES → CALCULATE MANIPULATED VARIABLE (OPENING OR THE LIKE) OF CONTROL VALVE — S06

NO

MANIPULATION OF CONTROL VALVE DESIRED? — S08 — NO

YES

MANIPULATE CONTROL VALVE — S09

STOP OF OPERATION? — S04 — NO

YES

SHUT DOWN CONTROL VALVE — S07

STOP OF OPERATION

# FIG. 5

## FIG. 6

START OF OPERATION

ACQUIRE DETECTION TEMPERATURES
Tout0, Tout1 FROM RESPECTIVE
BLOW-OFF AIR TEMPERATURE SENSORS — S01

WHICH VALVE CONTROL MODE IS SET? — S10

CONTROL AT MAXIMUM VALUE

CONTROL AT AVERAGE VALUE

$Tout0 \geq Tout1?$ — S11

NO

YES — S13

$T = (Tout0 + Tout1)/2$ — S12

$T = Tout0$ — S13

$T = Tout1$ — S14

START OF CONTROL OPERATION? — S02

YES

SET OPENING OF CONTROL VALVE TO INITIAL STATE — S05

NO

UNDER PID CONTROL? — S03

YES

CALCULATE MANIPULATED VARIABLE (OPENING OR THE LIKE) OF CONTROL VALVE — S06

MANIPULATION OF CONTROL VALVE DESIRED? — S08

NO

YES

MANIPULATE CONTROL VALVE — S09

NO

STOP OF OPERATION? — S04

NO

YES

SHUT DOWN CONTROL VALVE — S07

STOP OF OPERATION

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2009217500 A